(19) Europäisches Patentamt
European Patent Office
Office européen des brevets

(11) EP 4 180 490 A1

(12) EUROPEAN PATENT APPLICATION
published in accordance with Art. 153(4) EPC

(43) Date of publication:
17.05.2023 Bulletin 2023/20

(21) Application number: 21837602.8

(22) Date of filing: 05.07.2021

(51) International Patent Classification (IPC):
*C09D 11/16* (2014.01) *C09D 11/52* (2014.01)
*H01B 1/00* (2006.01) *H01B 1/22* (2006.01)
*H01B 13/00* (2006.01)

(52) Cooperative Patent Classification (CPC):
C09D 11/16; C09D 11/52; H01B 1/00; H01B 1/22; H01B 13/00

(86) International application number:
PCT/JP2021/025305

(87) International publication number:
WO 2022/009837 (13.01.2022 Gazette 2022/02)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 08.07.2020 JP 2020118058

(71) Applicant: Daicel Corporation
Osaka 530-0011 (JP)

(72) Inventor: TAKABAYASHI, Naofumi
Tokyo 108-8230 (JP)

(74) Representative: Grünecker Patent- und Rechtsanwälte
PartG mbB
Leopoldstraße 4
80802 München (DE)

# (54) CONDUCTIVE INK

(57) An object of the present disclosure is to provide a conductive ink that is excellent in applicability and dispersibility of metal nanoparticles, and forms, through sintering, a sintered body which is excellent in substrate steady contact and conductivity. The conductive ink according to an embodiment of the present disclosure contains components (A), (B), and (C) below, wherein a content of the component (C) is from 0.1 to 5.0 parts by weight relative to 100 parts by weight of the component (A), and a viscosity at 25°C is 100 mPa•s or less: Component (A): surface-modified metal nanoparticles having a configuration in which surfaces of metal nanoparticles are coated with an organic protective agent; Component (B): a dispersion medium containing an alcohol (b-1) and a hydrocarbon (b-2); and Component (C): a polyvinyl acetal resin.



Processed by Luminess, 75001 PARIS (FR)

## Description

### Technical Field

The present disclosure relates to a novel conductive ink, a method for manufacturing an electronic device using the conductive ink, and an electronic device including a sintered body of the conductive ink. The present application claims priority from the Japanese Patent Application No. 2020-118058, filed in Japan on July 8, 2020, the contents of which are incorporated herein by reference.

### Background Art

An electronic device (e.g., an electronic circuit) with a wire, an electrode, or the like (hereinafter, sometimes referred to as "wire or the like") has traditionally been formed by an etching method or the like. However, the formation process has been complicated, increasing the cost. A method of direct formation by printing has been investigated as an alternative to this.
Among metals, bulk silver has a high melting point of 962°C, but nano-sized silver particles (silver nanoparticles) fuse together at a temperature of approximately 100°C. Thus, use of silver nanoparticles can form a wire or the like with excellent conductivity on a general-purpose plastic substrate with low heat resistance. However, the nano-sized metal particles are problematically prone to agglomeration.
Patent Document 1 describes that coating surfaces of silver nanoparticles with an amine can suppress agglomeration; that a conductive ink obtained by dispersing the silver nanoparticles whose surfaces are coated with an amine in a dispersion medium containing from 10 to 50 wt.% of a hydrocarbon, such as n-octane, decalin, or tetradecane, and from 50 to 90 wt.% of an alcohol, such as n-butanol or cyclohexanemethanol, is excellent in dispersion stability of the silver nanoparticles and can be suitably used in applications of directly forming a wire or the like on a substrate by a printing method; and that a sintered body with excellent conductivity is obtained by sintering the conductive ink.

### Citation List

### Patent Document

Patent Document 1: WO 2014/021270

### Summary of Invention

### Technical Problem

However, since the sintered body obtained by using the conductive ink described in Patent Document 1 has low steady contact to the substrate, a protective film is sometimes bonded to a surface of the sintered body, for example, for the purpose of preventing damage to the sintered body during transport, but there is a problem that, when the protective film is peeled, the sintered body is also peeled from the substrate.
When a ceramic substrate is used as the substrate for forming a wire or the like, a certain degree of steady contact can be obtained between the substrate and the sintered body due to an anchoring effect generated by recesses and protrusions present on the surface of the substrate. However, there is a problem that, when a substrate with excellent surface smoothness such as a glass substrate is used, the anchoring effect cannot be obtained, and thus that the sintered body is easily peeled from the substrate. Also, it is conceivable to improve the steady contact of the substrate to the sintered body by applying a surface treatment to the substrate, but increases in number of processes and cost are problematically caused.
Therefore, a conductive ink containing metal nanoparticles is required to have the following properties 1 to 4:

1. the conductive ink has a viscosity suitable for application;
2. the conductive ink contains the metal nanoparticles in a highly dispersed state, and has a uniform composition;
3. a sintered body with excellent conductivity is obtained by sintering the conductive ink; and
4. a sintered body with excellent substrate steady contact is obtained by sintering the conductive ink.

As a method for improving the steady contact of the sintered body to the substrate, it is conceivable to add a tackifier such as a rubber-like elastic body, a terpene-based resin, a rosin-based resin, or a petroleum resin, a silane coupling agent, or the like. However, when these materials are added to the conductive ink, the applicability may decrease due to thickening, and the conductivity of the obtained sintered body may decrease.

Additionally, a method of adding a compound having a hydroxyl group, a carbonyl group, an ether bond, or the like and thus improving the steady contact of the sintered body to the substrate due to interaction such as hydrogen bonding is also conceivable. However, when these materials are added to the conductive ink, the metal nanoparticles are easily agglomerated, thereby making it difficult to keep the composition uniform.

That is, at present, a method for imparting the property 4 (substrate steady contact) to the conductive ink without impairing the properties 1 to 3 described above has not been found.

Accordingly, an object of the present disclosure is to provide a conductive ink that is excellent in applicability and dispersibility of metal nanoparticles, and forms, through sintering, a sintered body which is excellent in substrate steady contact and conductivity.

Another object of the present disclosure is to provide a method for manufacturing an electronic device using the conductive ink.

Still another object of the present disclosure is to provide an electronic device including a sintered body of the conductive ink.

Solution to Problem

As a result of diligent research to solve the above-described problems, the inventors of the present disclosure have found that, when metal nanoparticles whose surfaces are coated with an organic protective agent are dispersed in a specific dispersion medium, and a specific amount of a polyvinyl acetal resin is added to the conductive ink, excellent conductivity and substrate steady contact can be imparted to a sintered body of the conductive ink without impairing the applicability of the conductive ink or the dispersibility of the metal nanoparticles. The invention of the present disclosure was completed based on these findings.

In the present specification, the "nanoparticles" mean particles having a primary particle size (average primary particle diameter) of 0.1 nm or greater and less than 1000 nm. In addition, the particle diameter is determined by dynamic light scattering. Furthermore, the boiling point in the present specification is a value under normal pressure (760 mmHg).

The present disclosure provides a conductive ink containing components (A), (B), and (C) below, wherein a content of the component (C) is from 0.1 to 5.0 parts by weight relative to 100 parts by weight of the component (A), and a viscosity at 25°C is 100 mPa•s or less:

Component (A): surface-modified metal nanoparticles having a configuration in which surfaces of metal nanoparticles are coated with an organic protective agent;
Component (B): a dispersion medium containing an alcohol (b-1) and a hydrocarbon (b-2); and
Component (C): a polyvinyl acetal resin.

In the conductive ink, a total content of the alcohol (b-1) and the hydrocarbon (b-2) is preferably 70 wt.% or greater of a total amount of the component (B).

In the conductive ink, a content ratio of the alcohol (b-1) to the hydrocarbon (b-2) ((b-1)/(b-2) (weight ratio)) is preferably from 50/50 to 95/5.

In the conductive ink, the organic protective agent of the component (A) is preferably a compound having at least one type of functional group selected from the group consisting of a carboxyl group, a hydroxyl group, an amino group, a sulfo group, and a thiol group.

In the conductive ink, the organic protective agent of the component (A) is preferably a compound having at least an amino group.

In the conductive ink, the alcohol (b-1) is preferably an alicyclic secondary alcohol and/or an alicyclic tertiary alcohol.

In the conductive ink, the hydrocarbon (b-2) preferably includes an aliphatic hydrocarbon.

In the conductive ink, a weight average molecular weight of the polyvinyl acetal resin as the component (C) is preferably from $0.1 \times 10^4$ to $30.0 \times 10^4$.

In the conductive ink, the component (C) preferably contains a polyvinyl butyral resin.

In the conductive ink, the polyvinyl acetal resin as the component (C) preferably contains a polyvinyl acetal resin having a peak in a region from 1760 to 1800 $cm^{-1}$ in measurement by FT-IR.

A sintered body obtained by sintering the conductive ink at 120°C for 30 minutes may have a volume resistivity of 10 $\mu\Omega$cm or less.

In the conductive ink, the metal nanoparticles constituting the component (A) are preferably silver nanoparticles.

The conductive ink may be used in ink jet printing, dip coating printing, slit coating printing, spin coating printing, or spray printing.

The conductive ink preferably further contains a component (D) below:
Component (D): a dispersion stabilizer.

In the conductive ink, the dispersion stabilizer as the component (D) is preferably a compound having at least an amino group.

Also, the present disclosure provides a method for manufacturing the conductive ink, the method including:

mixing a component (B) and a component (C) to prepare a mixed solution; and
further mixing a component (A) with the mixed solution.

In the method for manufacturing the conductive ink, the mixing of the component (B) and the component (C) to prepare the mixed solution further includes mixing a component (D) below:
Component (D): a dispersion stabilizer.

Further, the present disclosure provides a method for manufacturing an electronic device, the method including:

applying the conductive ink on a substrate by ink jet printing, dip coating printing, slit coating printing, spin coating printing, or spray printing; and
sintering the conductive ink.

The present disclosure further provides an electronic device including a sintered body of the conductive ink on a substrate.

## Advantageous Effects of Invention

The conductive ink of the present disclosure has low viscosity and excellent applicability. The conductive ink of the present disclosure is applied to a surface of the substrate and then sintered, and thus forms a sintered body having excellent steady contact to the substrate. The sintered body has excellent conductivity.

## Brief Description of Drawing

FIG. 1 illustrates absorption peaks in a region from 1600 to 2000 $cm^{-1}$ of an FT-IR spectrum of a polyvinyl butyral resin "SV-02".

## Description of Embodiments

### [Conductive ink]

The conductive ink according to an embodiment of the present disclosure contains components (A), (B), and (C) below, wherein the content of the component (C) is from 0.1 to 5.0 parts by weight relative to 100 parts by weight of the component (A), and a viscosity at 25°C is 100 mPa•s or less:

Component (A): surface-modified metal nanoparticles having a configuration in which surfaces of metal nanoparticles are coated with an organic protective agent;
Component (B): a dispersion medium containing an alcohol (b-1) and a hydrocarbon (b-2); and
Component (C): a polyvinyl acetal resin.

### Surface-modified metal nanoparticles (A)

The surface-modified metal nanoparticles (A) in an embodiment of the present disclosure have a configuration in which surfaces of metal nanoparticles are coated with an organic protective agent. As such, in the surface-modified metal nanoparticles (A) in an embodiment of the present disclosure, spacing between the metal nanoparticles is ensured, and thus agglomeration is suppressed. That is, the surface-modified metal nanoparticles (A) in an embodiment of the present disclosure have excellent dispersibility.

The proportion of the organic protective agent in the surface-modified metal nanoparticles (A) is, for example, approximately from 1 to 20 wt.% (preferably, from 1 to 10 wt.%) of the weight of the metal nanoparticles. Each weight of the metal nanoparticles and the organic protective agent in the surface-modified metal nanoparticles can be determined, for example, from the weight loss rate in a certain temperature range by subjecting the surface-modified metal nanoparticles to thermogravimetry.

The average primary particle diameter of the metal nanoparticles in the surface-modified metal nanoparticles (A) is, for example, from 0.5 to 100 nm, preferably from 0.5 to 80 nm, more preferably from 1 to 70 nm, and even more preferably from 1 to 60 nm. The average primary particle diameter is determined by dynamic light scattering described

in the Examples.

The metal constituting the metal nanoparticles in the surface-modified metal nanoparticles (A) only need be a metal having the conductivity, and examples thereof include gold, silver, copper, nickel, aluminum, rhodium, cobalt, and ruthenium. Silver nanoparticles are preferred as the metal nanoparticles according to an embodiment of the present disclosure in that the silver nanoparticles are fused to each other at a temperature of approximately 100°C, and can form a wire or the like with excellent conductivity on a general-purpose plastic substrate with low heat resistance. Therefore, the surface-modified metal nanoparticles in an embodiment of the present disclosure are preferably surface-modified silver nanoparticles, and the conductive ink according to an embodiment of the present disclosure is preferably a silver ink.

The organic protective agent in the surface-modified metal nanoparticles (A) is preferably a compound having at least one type of functional group selected from the group consisting of a carboxyl group, a hydroxyl group, an amino group, a sulfo group, and a thiol group, particularly preferably a compound having from 4 to 18 carbon atoms and having at least one type of functional group selected from the group consisting of a carboxyl group, a hydroxyl group, an amino group, a sulfo group, and a thiol group, most preferably a compound having at least an amino group, and especially preferably a compound having from 4 to 18 carbon atoms and having an amino group (i.e., an amine having from 4 to 18 carbon atoms).

As the surface-modified metal nanoparticles (A), for example, the surface-modified silver nanoparticles can be manufactured by a manufacturing method or the like described below.

Dispersion medium (B)

The dispersion medium (B) in an embodiment of the present disclosure is a dispersion medium to disperse the surface-modified metal nanoparticles (A). The dispersion medium (B) contains at least an alcohol (b-1) and a hydrocarbon (b-2). One of each of the (b-1) and the (b-2) can be contained alone, or two or more thereof can be contained in combination. The (b-1) and the (b-2) each alone may be a liquid or solid under normal temperature and normal pressure, but the dispersion medium (B) containing these components together is a dispersion medium in a liquid state (a liquid dispersion medium) under normal temperature and normal pressure.

The conductive ink according to an embodiment of the present disclosure contains, as the dispersion medium (B), the (b-1) and the (b-2) in combination, and thus excellent dispersibility of the surface-modified metal nanoparticles (A) and dispersion stability are obtained.

Alcohol (b-1)

The (b-1) includes a primary alcohol, a secondary alcohol, and a tertiary alcohol. In an embodiment of the present disclosure, a secondary alcohol and/or a tertiary alcohol are/is particularly preferred in that the dispersibility of the surface-modified metal nanoparticles (A) can be stably maintained for a long time because loss of the organic protective agent is suppressed due to low reactivity with the organic protective agent of the surface-modified metal nanoparticles (A), i.e., excellent dispersion stability is obtained, and in that the sinterability of the metal nanoparticles is improved because the alcohol is rapidly evaporated even in low-temperature sintering, i.e., low-temperature sinterability can be imparted.

The (b-1) includes an aliphatic alcohol, an alicyclic alcohol, and an aromatic alcohol, and, among them, an alicyclic alcohol (i.e., an alcohol having an alicyclic structure) is preferred in terms of having excellent dispersibility of the surface-modified metal nanoparticles (A).

Thus, the (b-1) is preferably an alicyclic secondary alcohol and/or an alicyclic tertiary alcohol.

The alicyclic alcohol includes a monocyclic alcohol and a polycyclic alcohol, and the monocyclic alcohol is particularly preferred in that the monocyclic alcohol is particularly excellent in dispersibility of the surface-modified metal nanoparticles (A), and that low viscosity and excellent applicability (stability of ejection from a head nozzle when the conductive ink is applied by an inkjet printing method) are obtained.

The boiling point of the (b-1) is, for example, preferably 130°C or higher, and more preferably 170°C or higher. Particularly, when the surface-modified metal nanoparticles (A) are contained in a high concentration (e.g., when the content of the (A) (in terms of metal element) is 45 wt.% or greater of the total amount of the conductive ink), the boiling point is preferably 185°C or higher, and even more preferably 190°C or higher. The upper limit of the boiling point is, for example, 300°C, preferably 250°C, and particularly preferably 220°C. When the boiling point is 130°C or higher, volatilization at a temperature at the time of printing can be suppressed, and excellent applicability (stability of ejection from a head nozzle when the conductive ink is applied by an inkjet printing method) can be obtained. In addition, when the boiling point is 300°C or lower, the (b-1) rapidly volatilizes even in low-temperature sintering, and thus a sintered body with excellent conductivity can be obtained. In other words, the conductive ink has excellent low-temperature sinterability. On the other hand, when the boiling point falls below the range described above, fluidity of the conductive ink decreases

during application, and it may be difficult to form a uniform coating film. For example, if the conductive ink is applied by an ink jet printing method, the conductive ink would be prone to solidify and adhere to a nozzle orifice of the head, which would destabilize the ejection particularly when the ejection is intermittent, causing a risk of difficulty in accurately printing a desired pattern due to flight bending, or of clogging the nozzle orifice and disabling the ejection.

The monocyclic secondary alcohol is, for example, preferably cyclohexanol; a cyclohexanol that may have a substituent, such as 2-ethylcyclohexanol, 1-cyclohexylethanol, 3,5-dimethylcyclohexanol, 3,3,5-trimethylcyclohexanol, 2,3,5-trimethylcyclohexanol, 3,4,5-trimethylcyclohexanol, 2,3,4-trimethylcyclohexanol, 4-(tert-butyl)-cyclohexanol, 3,3,5,5-tetramethylcyclohexanol, or 2-isopropyl-5-methylcyclohexanol (i.e., menthol); or the corresponding cycloheptanol; in particular, preferably a cyclohexanol or cycloheptanol having an alkyl group having from 1 to 3 carbon atoms, and among them, a cyclohexanol having an alkyl group having from 1 to 3 carbon atoms is preferred.

The monocyclic tertiary alcohol is, for example, preferably a tertiary alcohol having a 6- to 7-membered ring (in particular, a cyclohexane ring) structure, such as 1-methylcyclohexanol, 4-isopropyl-1-methylcyclohexanol, 2-cyclohexyl-2-propanol, or 2-(4-methylcyclohexyl)-2-propanol.

The (b-1), in particular, preferably contain(s) at least a secondary alcohol (in particular, a monocyclic secondary alcohol) in terms of having excellent initial dispersibility of the surface-modified metal nanoparticles (A) and being able to maintain excellent dispersibility stably for a long period of time. The content of the secondary alcohol is, for example, preferably 60 wt.% or greater, more preferably 70 wt.% or greater, particularly preferably 80 wt.% or greater, and most preferably 90 wt.% or greater of the total amount of the (b-1). Note that the upper limit is 100 wt.%.

Hydrocarbon (b-2)

The (b-2) includes an aliphatic hydrocarbon, an alicyclic hydrocarbon, and an aromatic hydrocarbon. In an embodiment of the present disclosure, among them, an aliphatic hydrocarbon and/or an alicyclic hydrocarbon are/is preferred in terms of having particularly excellent dispersibility of the surface-modified metal nanoparticles (A).

The boiling point of the (b-2) is, for example, preferably 130°C or higher, more preferably 170°C or higher, and even more preferably 190°C or higher for the same reason as for the (b-1). Particularly, when the surface-modified metal nanoparticles (A) are contained in a high concentration (e.g., when the content of the (A) (in terms of metal element) is 45 wt.% or greater of the total amount of the conductive ink), the boiling point is preferably 200°C or higher, more preferably 230°C or higher, particularly preferably 250°C or higher, and most preferably 270°C or higher. In addition, the upper limit of the boiling point is, for example, 300°C.

The aliphatic hydrocarbon is, for example, preferably a chain aliphatic hydrocarbon having 10 or more (e.g., from 10 to 20) carbon atoms, such as n-decane, n-dodecane, n-tridecane, n-tetradecane, n-pentadecane, n-hexadecane, n-heptadecane, n-octadecane, and n-nonadecane, and among them, a chain aliphatic hydrocarbon having 12 or more (e.g., from 12 to 20 and preferably from 12 to 18) carbon atoms, and, in particular, 14 or more (e.g., from 14 to 20 and preferably from 14 to 18) carbon atoms are preferred.

Examples of the alicyclic hydrocarbon include monocyclic compounds, such as cyclohexanes, cyclohexenes, terpene-based 6-membered ring compounds, cycloheptane, cycloheptene, cyclooctane, cyclooctene, cyclodecane, and cyclododecene; and polycyclic compounds, such as bicyclo[2.2.2]octane and decalin.

Examples of the cyclohexanes include compounds with a 6-membered ring having an alkyl group having 2 or more (e.g., from 2 to 5) carbon atoms, such as ethylcyclohexane, n-propylcyclohexane, isopropylcyclohexane, n-butylcyclohexane, isobutylcyclohexane, sec-butylcyclohexane, and tert-butylcyclohexane; and bicyclohexyl.

Examples of the terpene-based 6-membered ring compounds include α-pinene, β-pinene, limonene, α-terpinene, β-terpinene, γ-terpinene, and terpinolene.

In particular, at least an aliphatic hydrocarbon (particularly preferably a chain aliphatic hydrocarbon, and most preferably a chain aliphatic hydrocarbon having 15 or more carbon atoms) is preferably contained as the (b-2) described above. The content of the aliphatic hydrocarbon is, for example, preferably 60 wt.% or greater, more preferably 70 wt.% or greater, particularly preferably 80 wt.% or greater, and most preferably 90 wt.% or greater of the total amount of the (b-2). Note that the upper limit is 100 wt.%.

Polyvinyl acetal resin (C)

The conductive ink according to an embodiment of the present disclosure contains a polyvinyl acetal resin (C) that exhibits good solubility in the alcohol (b-1) described above, in an amount from 0.1 to 5.0 parts by weight relative to 100 parts by weight of the component (A). Therefore, it is possible to impart excellent substrate steady contact (particularly, steady contact to a smooth substrate such as a glass substrate) to a sintered body of the conductive ink without impairing the applicability and without impairing the conductivity of the sintered body of the conductive ink.

The polyvinyl acetal resin (C) according to an embodiment of the present disclosure has at least a repeating unit represented by Formula (c) below.

[Chem. 1]

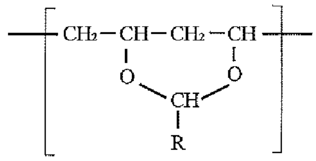

(c)

In Formula (c) above, R represents a hydrogen atom or an alkyl group having from 1 to 20 carbon atoms. Although not particularly limited, R in Formula (c) above is a hydrogen atom or an alkyl group having from 1 to 3 carbon atoms. More preferably, the polyvinyl acetal resin (C) includes a polyvinyl butyral resin wherein R in Formula (c) above is a propyl group. When R is an alkyl group having from 1 to 3 carbon atoms, the steady contact to the substrate is further improved.

In addition to the repeating unit represented by Formula (c) above (i.e., repeating unit represented by Formula (c-1) below), the polyvinyl acetal resin (C) may have another repeating unit. Preferred examples of the polyvinyl acetal resin (C) include those having repeating units represented by Formulas (c-1), (c-2), and (c-3) below.

[Chem. 2]

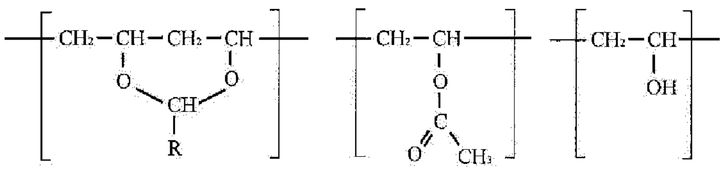

(c-1) (c-2) (c-3)

Also, the polyvinyl acetal resin (C) contained in the conductive ink according to an embodiment of the present disclosure is not particularly limited, but preferably has a peak in a region from 1760 to 1800 $cm^{-1}$ in measurement by FT-IR. The polyvinyl acetal resin (C) has a peak in the region from 1760 to 1800 $cm^{-1}$ in the measurement by FT-IR, thereby making it possible to improve the applicability of the conductive ink, and to improve the conductivity of the sintered body of the conductive ink and the substrate steady contact of the sintered body of the conductive ink (particularly, steady contact to a smooth substrate such as a glass substrate).

The "peak in the region from 1760 to 1800 $cm^{-1}$ in the measurement by FT-IR" means that the polyvinyl acetal resin (C) has an absorption peak which can be attributed to a desired functional group. The functional group to which a characteristic peak appearing in the region from 1760 to 1800 $cm^{-1}$ in the measurement by FT-IR is attributed is not particularly limited, but is preferably derived from, for example, a carboxylic acid, a salt thereof, an ester thereof, an anhydride thereof, a chloride thereof, or a derivative of any other carboxylic acid.

The weight average molecular weight of the polyvinyl acetal resin (C) (molecular weight in terms of polystyrene by GPC) is, for example, from $0.1 \times 10^4$ to $30.0 \times 10^4$, preferably from $0.5 \times 10^4$ to $20.0 \times 10^4$, particularly preferably from $0.5 \times 10^4$ to $10.0 \times 10^4$, most preferably from $0.5 \times 10^4$ to $5.0 \times 10^4$, and especially preferably from $0.5 \times 10^4$ to $3.0 \times 10^4$. When the polyvinyl acetal resin (C) has a molecular weight of $0.1 \times 10^4$ or greater, excellent substrate steady contact (particularly, steady contact to a smooth substrate such as a glass substrate) can be imparted to the sintered body of the conductive ink containing the polyvinyl acetal resin (C). Furthermore, when the molecular weight of the polyvinyl acetal resin (C) is $30.0 \times 10^4$ or less, the conductive ink containing the polyvinyl acetal resin (C) has good applicability, and provides a sintered body with good conductivity even through sintering in a short time at a low temperature.

If the molecular weight of the polyvinyl acetal resin (C) falls above the range described above, the solubility of the surface-modified metal nanoparticles in the dispersion medium (B) tends to decrease, and, even when the surface-modified metal nanoparticles are dissolved in the dispersion medium (B), excellent applicability tends to be difficult to obtain. Also, if the molecular weight of the polyvinyl acetal resin (C) falls below the range described above, even when it is added to the conductive ink, the effect of imparting the substrate steady contact tends to be difficult to obtain.

A glass transition temperature (Tg) of the polyvinyl acetal resin (C) is, for example, from 50 to 90°C, more preferably from 55 to 85°C, and even more preferably from 60 to 80°C. The glass transition temperature (Tg) of the polyvinyl acetal resin (C) can be measured, for example, by differential scanning calorimetry (DSC), dynamic viscoelasticity measurement, or the like.

The viscosity (measurement temperature: 20°C) of a 10 wt.% ethanol/toluene solution (ethanol : toluene mixing ratio: 1 : 1) of the polyvinyl acetal resin (C) is, for example, from 5 to 200 mPa•s, preferably from 7 to 100 mPa•s, and particularly preferably from 9 to 50 mPa•s. The viscosity can be measured using a falling-ball viscometer (e.g., Lovis 2000M) or a rotational viscometer (e.g., Model BM).

The polyvinyl acetal resin (C) can be manufactured, for example, by reacting an aldehyde with polyvinyl alcohol.

As the polyvinyl acetal resin (C), for example, trade names "Mowital B14S", "Mowital B 16H", "Mowital B20H " (all available from Kuraray Co., Ltd.), "S-LEC BL-1", "S-LEC BL-10", "S-LEC BL-S", "S-LEC SV-02", "S-LEC SV-05", "S-LEC SV-06", "S-LEC SV-12", "S-LEC SV-22", "S-LEC SV-16", and "S-LEC SV-26" (all available from Sekisui Chemical Co., Ltd.) can be used.

The conductive ink according to an embodiment of the present disclosure can contain, in addition to the above components (A) to (C), an additive such as a dispersant, a surface energy modifier, a plasticizer, a leveling agent, an antifoaming agent, or a dispersion stabilizer described below, as necessary.

Method for manufacturing conductive ink

The conductive ink according to an embodiment of the present disclosure can be manufactured as follows. First, surface-modified metal nanoparticles (A) are manufactured, for example, through mixing a metal compound and an organic protective agent to form a complex containing the metal compound and the organic protective agent (complex formation), thermally decomposing the complex (thermal decomposition), and, as necessary, washing the reaction product (washing). Then, the conductive ink is manufactured through mixing the obtained surface-modified metal nanoparticles (A) with a dispersion medium (B) and a polyvinyl acetal resin (C) (preparation of the conductive ink).

Formation of complex

The formation of the complex is to mix a metal compound and an organic protective agent to form a complex containing the metal compound and the organic protective agent. In an embodiment of the present disclosure, it is preferable to use a silver compound as the metal compound in that the nano-sized silver particles are fused to each other at a temperature of approximately 100°C, and thus a wire or the like having excellent conductivity can be formed on a general-purpose plastic substrate with low heat resistance. Particularly, a silver compound that is readily decomposed upon heating and produces metallic silver is preferably used. Examples of such a silver compound include silver carboxylates, such as silver formate, silver acetate, silver oxalate, silver malonate, silver benzoate, and silver phthalate; silver halides, such as silver fluoride, silver chloride, silver bromide, and silver iodide; and silver sulfate, silver nitrate, and silver carbonate. In an embodiment of the present disclosure, among them, silver oxalate is preferred in that it has a high silver content and can be thermally decomposed without using a reducing agent, and thus that an impurity derived from the reducing agent is less likely to be mixed into the conductive ink.

As the organic protective agent, a compound having at least one type of functional group selected from the group consisting of a carboxyl group, a hydroxyl group, an amino group, a sulfo group, and a thiol group, in that the coordination of non-covalent electron pairs in the heteroatom to the metal nanoparticles can exert an effect of strongly suppressing agglomeration between the metal nanoparticles. A compound having from 4 to 18 carbon atoms and having at least one type of functional group selected from the group consisting of a carboxyl group, a hydroxyl group, an amino group, a sulfo group, and a thiol group is particularly preferred.

The organic protective agent is preferably a compound having an amino group, and most preferably a compound having from 4 to 18 carbon atoms and having an amino group, that is, an amine having from 4 to 18 carbon atoms.

The amine is a compound in which at least one hydrogen atom of ammonia is substituted with a hydrocarbon group, and includes a primary amine, a secondary amine, and a tertiary amine. In addition, the amine may be a monoamine or a polyamine, such as a diamine. One of these can be used alone or two or more in combination.

The amine preferably contains at least one selected from a monoamine (1) having 6 or more carbon atoms in total and represented by Formula (a-1) below, where $R^1$, $R^2$, and $R^3$ are identical or different and are hydrogen atoms or monovalent hydrocarbon groups (with the provision that the case in which $R^1$, $R^2$, and $R^3$ are all hydrogen atoms is omitted); monoamine (2) having 5 or less carbon atoms in total and represented by Formula (a-1) below, where $R^1$, $R^2$, and $R^3$ are identical or different and are hydrogen atoms or monovalent hydrocarbon groups (with the provision that the case in which $R^1$, $R^2$, and $R^3$ are all hydrogen atoms is omitted); and a diamine (3) having 8 or less carbon atoms in total and represented by Formula (a-2), where $R^4$ to $R^7$ are identical or different and are hydrogen atoms or monovalent hydrocarbon groups, and $R^8$ is a divalent hydrocarbon group; and in particular, preferably contains the monoamine (1) in combination with the monoamine (2) and/or the diamine (3).

[Chem. 3]

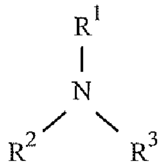

(a-1)

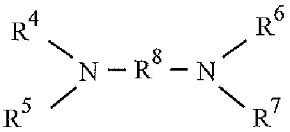

(a-2)

The hydrocarbon group includes an aliphatic hydrocarbon group, an alicyclic hydrocarbon group, and an aromatic hydrocarbon group, and among them, an aliphatic hydrocarbon group or an alicyclic hydrocarbon group is preferred, and in particular, an aliphatic hydrocarbon group is preferred. Thus, the monoamine (1), the monoamine (2), and the diamine (3) are preferably an aliphatic monoamine (1), an aliphatic monoamine (2), and an aliphatic diamine (3).

In addition, the monovalent aliphatic hydrocarbon group includes an alkyl group and an alkenyl group. The monovalent alicyclic hydrocarbon group includes a cycloalkyl group and a cycloalkenyl group. Furthermore, the divalent aliphatic hydrocarbon group includes an alkylene group and an alkenylene group, and the divalent alicyclic hydrocarbon group includes a cycloalkylene group and a cycloalkenylene group.

Examples of the monovalent hydrocarbon group in $R^1$, $R^2$, and $R^3$ may include alkyl groups having approximately from 1 to 18 carbon atoms, such as a methyl group, an ethyl group, a propyl group, an isopropyl group, a butyl group, an isobutyl group, an sec-butyl group, a tert-butyl group, a pentyl group, a hexyl group, a decyl group, a dodecyl group, a tetradecyl group, an octadecyl group; alkenyl groups having approximately from 2 to 18 carbon atoms, such as a vinyl group, an allyl group, a methallyl group, a 1-propenyl group, an isopropenyl group, a 1-butenyl group, a 2-butenyl group, a 3-butenyl group, a 1-pentenyl group, a 2-pentenyl group, a 3-pentenyl group, a 4-pentenyl group, and a 5-hexenyl group; cycloalkyl groups having approximately from 3 to 18 carbon atoms, such as a cyclopropyl group, a cyclobutyl group, a cyclopentyl group, a cyclohexyl group, and a cyclooctyl group; and cycloalkenyl groups having approximately from 3 to 18 carbon atoms, such as a cyclopentenyl group and a cyclohexenyl group.

Examples of the monovalent hydrocarbon groups in $R^4$ to $R^7$ may include, among those exemplified above, alkyl groups having approximately from 1 to 7 carbon atoms, alkenyl groups having approximately from 2 to 7 carbon atoms, cycloalkyl groups having approximately from 3 to 7 carbon atoms, and cycloalkenyl groups having approximately from 3 to 7 carbon atoms.

Examples of the divalent hydrocarbon group in $R^8$ may include alkylene groups having from 1 to 8 carbon atoms, such as a methylene group, a methylmethylene group, a dimethylmethylene group, an ethylene group, a propylene group, a trimethylene group, a tetramethylene group, a pentamethylene group, and a heptamethylene group; and alkenylene groups having from 2 to 8 carbon atoms, such as a vinylene group, a propenylene group, a 1-butenylene group, a 2-butenylene group, a butadienylene group, a pentenylene group, a hexenylene group, a heptenylene group, and an octenylene group.

The hydrocarbon groups in the above $R^1$ to $R^8$ may have a substituent of various types [e.g., such as a halogen atom, an oxo group, a hydroxyl group, a substituted oxy group (e.g., such as a $C_{1-4}$ alkoxy group, a $C_{6-10}$ aryloxy group, a $C_{7-16}$ aralkyloxy group, or a $C_{1-4}$ acyloxy group), a carboxyl group, a substituted oxycarbonyl group (e.g., such as a $C_{1-4}$ alkoxycarbonyl group, a $C_{6-10}$ aryloxycarbonyl group, or a $C_{7-16}$ aralkyloxycarbonyl group), a cyano group, a nitro group, a sulfo group, or a heterocyclic group]. In addition, the hydroxyl group and the carboxyl group may be protected with a protecting group commonly used in the field of organic synthesis.

The monoamine (1) is a compound that is adsorbed on the surfaces of the metal nanoparticles and prevents agglomeration of the metal nanoparticles and enlargement of the agglomeration, that is, a compound having a function of imparting high dispersibility to the metal nanoparticles. Examples of the monoamine (1) include primary monoamines having a linear alkyl group, such as n-hexylamine, n-heptylamine, n-octylamine, n-nonylamine, n-decylamine, n-undecylamine, and n-dodecylamine; primary amines having a branched alkyl group, such as isohexylamine, 2-ethylhexylamine, and tert-octylamine; a primary amine having a cycloalkyl group, such as cyclohexylamine; a primary amine having an alkenyl group, such as oleylamine; secondary amines having a linear alkyl group, such as N,N-dipropylamine, N,N-dibutylamine, N,N-dipentylamine, N,N-dihexylamine, N,N-dipeptylamine, N,N-dioctylamine, N,N-dinonylamine, N,N-didecylamine, N,N-diundecylamine, N,N-didodecylamine, and N-propyl-N-butylamine; secondary amines having a

branched alkyl group, such as N,N-diisohexylamine and N,N-di(2-ethylhexyl)amine; tertiary amines having a linear alkyl group, such as tributylamine and trihexylamine; and tertiary amines having a branched alkyl group, such as triisohexylamine and tri(2-ethylhexyl)amine.

Among the above monoamines (1), an amine (in particular, a primary amine) having a linear alkyl group having from 6 to 18 carbon atoms in total (more preferably up to 16 and particularly preferably up to 12 carbon atoms in total) is preferred in that such an amine can provide space between the metal nanoparticles when the amino groups is adsorbed on the metal nanoparticle surfaces, thus providing the effect of preventing agglomeration of the metal nanoparticles, and such an amine can be easily removed during sintering. In particular, n-hexylamine, n-heptylamine, n-octylamine, n-nonylamine, n-decylamine, n-undecylamine, n-dodedeyclamine, and the like are preferred.

The monoamine (2) has a shorter hydrocarbon chain than that of the monoamine (1), and thus the function of the monoamine (2) itself to impart high dispersibility to the metal nanoparticles is low. However, the monoamine (2) has a high coordination ability to a metal atom due to its higher polarity than that of the monoamine (1), and thus has an effect of promoting complex formation. In addition, the monoamine (2) has a short hydrocarbon chain and thus can be removed from the metal nanoparticle surfaces in a short time (e.g., not longer than 30 minutes and preferably not longer than 20 minutes) even in low-temperature sintering, thus providing a sintered body with excellent conductivity.

Examples of the monoamine (2) include a primary amine having a linear or branched alkyl group and having from 2 to 5 carbon atoms in total (preferably from 4 to 5 carbon atoms in total), such as n-butylamine, isobutylamine, sec-butylamine, tert-butylamine, pentylamine, isopentylamine, and tert-pentylamine; and a secondary amine having a linear or branched alkyl group and having from 2 to 5 carbon atoms in total (preferably from 4 to 5 carbon atoms in total), such as N,N-diethylamine. In an embodiment of the present disclosure, among these, a primary amine having a linear alkyl group and having from 2 to 5 carbon atoms in total (preferably from 4 to 5 carbon atoms in total) is preferred.

The diamine (3) has 8 or less carbon atoms in total and has a high coordination ability to a metal atom due to its higher polarity than that of the monoamine (1), and thus has an effect of promoting complex formation. In addition, the diamine (3) has an effect of promoting thermal decomposition of the complex at lower temperature and in a short time in the thermal decomposition of the complex, and the use of the diamine (3) enables the production of the surface-modified metal nanoparticles more efficiently. Furthermore, the surface-modified metal nanoparticles having a configuration of being coated with the protective agent containing the diamine (3) exhibit excellent dispersion stability in a highly polar dispersion medium. Moreover, the diamine (3) has a short hydrocarbon chain and thus can be removed from the metal nanoparticle surfaces in a short time (e.g., not longer than 30 minutes and preferably not longer than 20 minutes) even by low-temperature sintering, thus providing a sintered body with excellent conductivity.

Examples of the diamine (3) may include: diamines in which $R^4$ to $R^7$ in Formula (a-2) are hydrogen atoms, and $R^8$ is a linear or branched alkylene group, such as 2,2-dimethyl-1,3-propanediamine, 1,4-butanediamine, 1,5-pentanediamine, 1,6-hexanediamine, 1,7-heptanediamine, 1,8-octanediamine, and 1,5-diamino-2-methylpentane; diamines in which $R^4$ and $R^6$ in Formula (a-2) are identical or different and linear or branched alkyl groups, $R^5$ and $R^7$ are hydrogen atoms, and $R^8$ is a linear or branched alkylene group, such as N,N'-dimethylethylenediamine, N,N'-diethylethylenediamine, N,N'-dimethyl-1,3-propanediamine, N,N'-diethyl-1,3-propanediamine, N,N'-dimethyl-1,4-butanediamine, N,N'-diethyl-1,4-butanediamine, and N,N'-dimethyl-1,6-hexanediamine; and diamines in which $R^4$ and $R^5$ in Formula (a-2) are identical or different and linear or branched alkyl groups, $R^6$ and $R^7$ are hydrogen atoms, and $R^8$ is a linear or branched alkylene group, such as N,N-dimethylethylenediamine, N,N-diethylethylenediamine, N,N-dimethyl-1,3-propanediamine, N,N-diethyl-1,3-propanediamine, N,N-dimethyl-1,4-butanediamine, N,N-diethyl-1,4-butanediamine, and N,N-dimethyl-1,6-hexanediamine.

Among them, diamines in which $R^4$ and $R^5$ in Formula (a-2) above are identical or different and linear or branched alkyl groups, $R^6$ and $R^7$ are hydrogen atoms, and $R^8$ is a linear or branched alkylene group [in particular, diamines in which $R^4$ and $R^5$ in Formula (a-2) are linear alkyl groups, $R^6$ and $R^7$ are hydrogen atoms, and $R^8$ is a linear alkylene group] are preferred.

In diamines in which $R^4$ and $R^5$ in Formula (a-2) are identical or different and are linear or branched alkyl groups, and $R^6$ and $R^7$ are hydrogen atoms, that is, diamines having a primary amino group and a tertiary amino group, the primary amino group has a high coordination ability to a metal atom, but the tertiary amino group has a poor coordination ability to a metal atom, and thus this prevents a resulting complex from becoming excessively complicated, thereby allowing the complex to be thermally decomposed at lower temperature and in a shorter time in the thermal decomposition of the complex. Among them, diamines having 6 or less (e.g., from 1 to 6, preferably from 4 to 6) carbon atoms in total are preferred, and diamines having 5 or less (e.g., from 1 to 5, preferably from 4 to 5) carbon atoms in total are more preferred in that they can be removed from the metal nanoparticle surfaces in a short time in low-temperature sintering.

The proportion of the content of the monoamine (1) in the total amount of the organic protective agent contained in the conductive ink according to an embodiment of the present disclosure, and the proportion of the total content of the monoamine (2) and the diamine (3) therein are preferably within the ranges described below.

Content of monoamine (1): for example, from 5 to 65 mol% (the lower limit is preferably 10 mol%, particularly

preferably 20 mol%, and most preferably 30 mol%. In addition, the upper limit is preferably 60 mol%, and particularly preferably 50 mol%)

Total content of monoamine (2) and diamine (3): for example, from 35 to 95 mol% (the lower limit is preferably 40 mol%, and particularly preferably 50 mol%. In addition, the upper limit is preferably 90 mol%, particularly preferably 80 mol%, and most preferably 70 mol%)

The proportion of the content of the monoamine (2) in the total amount of the organic protective agent contained in the conductive ink according to an embodiment of the present disclosure, and the proportion of the content of the diamine (3) therein are preferably within the ranges described below.

Content of monoamine (2): for example, from 5 to 65 mol% (the lower limit is preferably 10 mol%, particularly preferably 20 mol%, and most preferably 30 mol%. In addition, the upper limit is preferably 60 mol%, and particularly preferably 50 mol%)

Content of diamine (3): for example, from 5 to 50 mol% (the lower limit is preferably 10 mol%. In addition, the upper limit is preferably 40 mol%, and particularly preferably 30 mol%)

The monoamine (1) contained in the above range provides dispersion stability of the metal nanoparticles. With the content of the monoamine (1) below the above range, the metal nanoparticles would tend to be prone to agglomeration. On the other hand, the content of the monoamine (1) exceeding the above range would cause difficulty in removing the organic protective agent from the metal nanoparticle surfaces in a short time when the sintering temperature is low, tending to reduce the conductivity of the resulting sintered body.

The monoamine (2) contained in the above range provides the effect of promoting complex formation. In addition, this allows the organic protective agent to be removed from the metal nanoparticle surfaces in a short time even when the sintering temperature is low, providing a sintered body with excellent conductivity.

The diamine (3) contained in the above range easily provides the effect of promoting complex formation and the effect of promoting the thermal decomposition of the complex. In addition, the surface-modified metal nanoparticles having a configuration of being coated with the protective agent containing the diamine (3) exhibit excellent dispersion stability in a highly polar dispersion medium.

In an embodiment of the present disclosure, the use of the monoamine (2) and/or the diamine (3) having a high coordination ability to metal atoms of the metal compound is preferred, in that the use can reduce the amount of the monoamine (1) used depending on the proportion of the monoamine (2) and/or the diamine (3) used and can remove the organic protective agent from the metal nanoparticle surfaces in a short time even when the sintering temperature is low, providing a sintered body with excellent conductivity.

The amine used as the organic protective agent in an embodiment of the present disclosure may contain an additional amine other than the monoamine (1), the monoamine (2), and the diamine (3), but the proportion of the total content of the monoamine (1), the monoamine (2), and the diamine (3) accounting for the total amines contained in the protective agent is, for example, preferably from 60 wt.% or greater, particularly preferably 80 wt.% or greater, and most preferably 90 wt.% or greater. Note that the upper limit is 100 wt.%. That is, the content of the additional amine is preferably 40 wt.% or less, particularly preferably 20 wt.% or less, and most preferably 10 wt.% or less.

The amount of the organic protective agent [in particular, monoamine (1) + monoamine (2) + diamine (3)] used is not particularly limited, but is preferably approximately from 1 to 50 mol, particularly preferably from 2 to 50 mol, and most preferably from 6 to 50 mol, relative to 1 mol of metal atoms in the metal compound of the raw material. When the amount of the organic protective agent falls below the above range, the metal compound not converted to a complex would be prone to remain in the formation of the complex, tending to be difficult to impart sufficient dispersibility to the metal nanoparticles.

In an embodiment of the present disclosure, for the purpose of further improving the dispersibility of the metal nanoparticles, one or more types of compounds having a carboxyl group (for example, compounds having from 4 to 18 carbon atoms and having a carboxyl group, preferably aliphatic monocarboxylic acids having from 4 to 18 carbon atoms) may be contained together with the compound having an amino group as the organic protective agent.

Examples of the aliphatic monocarboxylic acid may include saturated aliphatic monocarboxylic acids having 4 or more carbon atoms, such as butanoic acid, pentanoic acid, hexanoic acid, heptanoic acid, octanoic acid, nonanoic acid, decanoic acid, undecanoic acid, dodecanoic acid, tridecanoic acid, tetradecanoic acid, pentadecanoic acid, hexadecanoic acid, heptadecanoic acid, octadecanoic acid, nonadecanoic acid, and icosanoic acid; and unsaturated aliphatic monocarboxylic acids having 8 or more carbon atoms, such as oleic acid, elaidic acid, linoleic acid, palmitoleic acid, and eicosenoic acid.

Among them, saturated or unsaturated aliphatic monocarboxylic acids having from 8 to 18 carbon atoms (in particular, octanoic acid and oleic acid) are preferred. When the carboxyl groups of the aliphatic monocarboxylic acid are adsorbed on the metal nanoparticle surfaces, the saturated or unsaturated aliphatic hydrocarbon chain having from

8 to 18 carbon atoms causes a steric hindrance and thus can provide space between the metal nanoparticles, thus improving the effect of preventing agglomeration of the metal nanoparticles.

The amount of the compound having a carboxyl group used is, for example, approximately from 0.05 to 10 mol, preferably from 0.1 to 5 mol, and particularly preferably from 0.5 to 2 mol, relative to 1 mol of metal atoms in the metal compound. The amount of the compound having a carboxyl group used below the above range would cause difficulty in providing an effect of improving dispersion stability. On the other hand, the compound having a carboxyl group, even when used in an excessive amount, would saturate the effect of improving the dispersion stability while it tends to be difficult to remove the compound by low-temperature sintering.

The reaction between the organic protective agent and the metal compound is performed in the presence or absence of the dispersion medium. As the dispersion medium, for example, an alcohol having 3 or more carbon atoms can be used.

Examples of the alcohol having 3 or more carbon atoms include n-propanol (boiling point: 97°C), isopropanol (boiling point: 82°C), n-butanol (boiling point: 117°C), isobutanol (boiling point: 107.89°C), sec-butanol (boiling point: 99.5°C), tert-butanol (boiling point: 82.45°C), n-pentanol (boiling point: 136°C), n-hexanol (boiling point: 156°C), n-octanol (boiling point: 194°C), and 2-octanol (boiling point: 174°C). Among them, alcohols having from 4 to 6 carbon atoms are preferred, and in particular, n-butanol and n-hexanol are preferred in that higher temperature can be set for the thermal decomposition of the complex to be performed later and in terms of the convenience of the post-treatment of the resulting surface-modified metal nanoparticles.

In addition, the amount of the dispersion medium used is, for example, 120 parts by weight or greater, preferably 130 parts by weight or greater, and more preferably 150 parts by weight or greater, relative to 100 parts by weight of the metal compound. The upper limit of the amount of the dispersion medium used is, for example, 1000 parts by weight, preferably 800 parts by weight, and particularly preferably 500 parts by weight.

The reaction between the organic protective agent and the metal compound is preferably performed at ordinary temperature (from 5 to 40°C). The reaction is accompanied by heat generation due to the coordination reaction of the organic protective agent to the metal compound, and thus may be performed while the reaction mixture is appropriately cooled to the above temperature range.

The reaction time between the organic protective agent and the metal compound is, for example, approximately from 30 minutes to 3 hours. This results in a metal-organic protective agent complex (metal-amine complex when an amine is used as the organic protective agent).

Thermal decomposition

The thermal decomposition is to thermally decompose the resulting metal-organic protective agent complex through the formation of the complex, to form the surface-modified metal nanoparticles. It is believed that the metal-organic protective agent complex is heated to cause thermal decomposition of the metal compound to form metal atoms while maintaining coordination bonding of the organic protective agent to the metal atoms, and then agglomeration of the metal atoms to which the organic protective agent is coordinated, leading to formation of metal nanoparticles that are coated with an organic protective film.

The thermal decomposition is preferably performed in the presence of a dispersion medium, and the alcohol described above can be suitably used as the dispersion medium. In addition, the thermal decomposition temperature is to be a temperature at which the surface-modified metal nanoparticles are formed, and when the metal-organic protective agent complex is a silver oxalate-organic protective agent complex, the temperature is, for example, approximately from 80 to 120°C, preferably from 95 to 115°C, and particularly preferably from 100 to 110°C. In terms of preventing the elimination of the surface modification portion of the surface-modified metal nanoparticle, the thermal decomposition is preferably performed at a temperature as low as possible within the above temperature range. The thermal decomposition duration is, for example, approximately from 10 minutes to 5 hours.

In addition, the thermal decomposition of the metal-organic protective agent complex is preferably performed in an air atmosphere or in an inert gas atmosphere, such as argon.

Washing

The excess organic protective agent, if present after the completion of the thermal decomposition reaction of the metal-organic protective agent complex, is preferably removed by decantation, which may be repeated once or more times as necessary. In addition, the surface-modified metal nanoparticles after the completion of the decantation is preferably subjected to the preparation of the conductive ink described below in a wet state without drying or solidifying in that this can prevent re-agglomeration of the surface-modified metal nanoparticles and maintain high dispersibility.

Decantation is performed, for example, by washing the surface-modified metal nanoparticles in a suspended state with a cleaning agent, precipitating the surface-modified metal nanoparticles by centrifugation, and removing the

supernatant. The cleaning agent used is preferably one or more types of linear or branched alcohols having from 1 to 4 (preferably from 1 to 2) carbon atoms, such as methanol, ethanol, n-propanol, or isopropanol in terms of achieving good precipitation of the surface-modified metal nanoparticles and efficiently separating and removing the cleaning agent by centrifugation after the washing.

Preparation of conductive ink

The preparation of the conductive ink is to mix the surface-modified metal nanoparticles (A) (preferably, the surface-modified metal nanoparticles (A) in a wet state) obtained through the above processes, the dispersion medium (B), the polyvinyl acetal resin (C), and, as necessary, an additive to prepare the conductive ink according to an embodiment of the present disclosure. For the mixing, a commonly known mixing apparatus, such as, for example, a self-rotating stirring defoaming apparatus, a homogenizer, a planetary mixer, a three-roll mill, or a bead mill, can be used. In addition, each component may be mixed at the same time or sequentially. The mixing portion of each component can be appropriately adjusted in the range described below.

A procedure for preparing the conductive ink is not particularly limited, but, for example, it is preferable to dissolve the polyvinyl acetal resin (C) and the dispersion stabilizer described above as the additive in the dispersion medium (B) and then to mix the resulting solution with the surface-modified metal nanoparticles (A), from the perspective of dispersion stability of the conductive ink.

The dispersion stabilizer to be mixed with the polyvinyl acetal resin (C) is not particularly limited, and a compound having at least an amino group can be used, for example. As the "compound having at least an amino group" as the dispersion stabilizer, the same compound as the "compound having at least an amino group" as the organic protective agent described above can be used. The dispersion stabilizer may be identical with or different from the organic protective agent used in the preparation of the surface-modified metal nanoparticles (A).

The use amount of the dispersion stabilizer to be mixed with the polyvinyl acetal resin (C) is not particularly limited, but is preferably from 10 to 500 parts by weight, and more preferably from 50 to 300 parts by weight relative to 100 parts by weight of the polyvinyl acetal resin (C), from the perspective of dispersion stability of the conductive ink.

The content of the surface-modified metal nanoparticles (A) (in terms of metal elements) in the total amount (100 wt.%) of the conductive ink according to an embodiment of the present disclosure is, for example, approximately from 35 to 70 wt.%. The lower limit is preferably 40 wt.%, particularly preferably 45 wt.%, most preferably 50 wt.%, and particularly preferably 55 wt.% from the perspective of obtaining a coating film or sintered body with a higher film thickness. The upper limit is preferably 65 wt.%, and particularly preferably 60 wt.% from the perspective of applicability (stability of ejection from a head nozzle when the conductive ink is applied by an inkjet printing method).

The content of the dispersion medium (B) in the conductive ink according to an embodiment of the present disclosure is, for example, from 20 to 100 parts by weight, preferably from 30 to 90 parts by weight, more preferably from 40 to 80 parts by weight, even more preferably from 50 to 75 parts by weight, particularly preferably from 55 to 75 parts by weight, and most preferably from 60 to 75 parts by weight relative to 100 parts by weight of the surface-modified metal nanoparticles (A).

The content of the dispersion medium (B) in the total amount (100 wt.%) of the conductive ink according to an embodiment of the present disclosure is, for example, from 20 to 65 wt.%, preferably from 25 to 60 wt.%, more preferably from 30 to 55 wt.%, and most preferably from 30 to 50 wt.%. The conductive ink according to an embodiment of the present disclosure contains the dispersion medium (B) in an amount within the range described above and thus has excellent applicability. The conductive ink, for example, when applied by an ink jet printing method, can well maintain stability of ejection from the nozzle of the head.

The content of the (b-1) (particularly, monocyclic secondary alcohol) is, for example, from 15 to 70 parts by weight, preferably from 20 to 60 parts by weight, particularly preferably from 30 to 55 parts by weight, and most preferably from 35 to 55 parts by weight relative to 100 parts by weight of the surface-modified metal nanoparticles (A).

The content of the (b-2) (particularly, aliphatic hydrocarbon) is, for example, from 5 to 50 parts by weight, preferably from 10 to 40 parts by weight, particularly preferably from 15 to 30 parts by weight, and most preferably from 15 to 28 parts by weight relative to 100 parts by weight of the surface-modified metal nanoparticles (A).

The content ratio of the (b-1) to the (b-2) ((b-1)/(b-2)) in the total amount of the dispersion medium (B) contained in the conductive ink according to an embodiment of the present disclosure is, for example, from 40/60 to 95/5, preferably from 45/55 to 90/10, more preferably from 50/50 to 85/15, and particularly preferably from 60/40 to 80/20. The content of the (b-1) below the above range would tend to reduce the smoothness of the coating film and additionally would tend to reduce the low-temperature sintering properties. On the other hand, the content of the (b-2) below the above range would tend to reduce the applicability.

The dispersion medium (B) according to an embodiment of the present disclosure may contain one or more types of additional dispersion media in addition to the (b-1) and the (b-2), but the total content of the (b-1) and the (b-2) is preferably 70 wt.% or greater, particularly preferably 75 wt.% or greater, and most preferably 80 wt.% or greater of

the total amount of the dispersion medium (B). Therefore, the content of the additional dispersion medium (when two or more types of additional dispersion media are contained, the total amount thereof) is preferably 30 wt.% or less, particularly preferably 25 wt.% or less, and most preferably 20 wt.% or less of the total amount of the dispersion medium (B). With the content of the additional dispersion medium exceeding the above range, the applicability would decrease due to thickening, or the metal nanoparticles would be prone to agglomeration, tending to reduce the dispersibility.

Furthermore, the content of the primary alcohol in the total amount (100 wt.%) of the dispersion medium (B) contained in the conductive ink according to an embodiment of the present disclosure is preferably approximately 30 wt.% or less, more preferably 25 wt.% or less, particularly preferably 20 wt.% or less, most preferably 15 wt.% or less, and especially preferably 5 wt.% or less.

The content of the polyvinyl acetal resin (C) in the conductive ink according to an embodiment of the present disclosure is from 0.1 to 5.0 parts by weight relative to 100 parts by weight (in terms of metal element) of the surface-modified metal nanoparticles (A), and the lower limit thereof is preferably 0.2 parts by weight, particularly preferably 0.3 parts by weight, most preferably 0.4 parts by weight, and particularly preferably 0.5 parts by weight. The upper limit of the content is preferably 3.0 parts by weight, particularly preferably 2.0 parts by weight, and most preferably 1.0 part by weight. When the polyvinyl acetal resin (C) is used in an amount within a range of 0.1 parts by weight or greater, a sintered body with excellent substrate steady contact can be obtained. Furthermore, when the polyvinyl acetal resin (C) is used in an amount within a range of 5.0 parts by weight or less, a sintered body with excellent conductivity can be obtained.

The content of the polyvinyl acetal resin (C) in the total amount (100 wt.%) of the conductive ink according to an embodiment of the present disclosure is from 0.05 to 3.0 wt.%, and the lower limit thereof is preferably 0.1 wt.%, particularly preferably 0.15 wt.%, most preferably 0.2 wt.%, and particularly preferably 0.25 wt.%. The upper limit of the content is preferably 2.5 wt.%, particularly preferably 2.0 wt.%, and most preferably 1.0 wt.% When the polyvinyl acetal resin (C) is used in an amount within a range of 0.05 wt.% or greater, a sintered body with excellent substrate steady contact can be obtained. Furthermore, when the polyvinyl acetal resin (C) is used in an amount within a range of 3.0 wt.% or less, a sintered body with excellent conductivity can be obtained.

In addition, the conductive ink according to an embodiment of the present disclosure may contain an additional polymer (a compound having a molecular weight of $0.1 \times 10^4$ or greater) in addition to the polyvinyl acetal resin (C), but the proportion of the polyvinyl acetal resin (C) in the total polymer contained in the conductive ink is, for example, 50 wt.% or greater, preferably 70 wt.% or greater, particularly preferably 80 wt.% or greater, and most preferably 90 wt.% or greater. The upper limit of the proportion is 100 wt.%.

Therefore, the content of the additional polymer is, for example, 50 wt.% or less, preferably 30 wt.% or less, particularly preferably 20 wt.% or less, and most preferably 10 wt.% or less of the total polymer contained in the conductive ink. The lower limit of the content is zero.

The proportion of the total amount of the surface-modified metal nanoparticles (A), the dispersion medium (B) and the polyvinyl acetal resin (C) in the total amount (100 wt.%) of the conductive ink according to an embodiment of the present disclosure is, for example, 70 wt.% or greater, preferably 80 wt.% or greater, and particularly preferably 90 wt.% or greater.

The viscosity (mPa•s) of the conductive ink according to an embodiment of the present disclosure can be measured using a rotational viscometer (e.g., Lovis 2000M), a capillary viscometer, a falling-ball viscometer (e.g., Model BM), a cup type viscometer, or the like. The viscosity at 25°C of the conductive ink according to an embodiment of the present disclosure, as measured, for example, using a falling-ball viscometer, is 100 mPa•s or less (for example, from 2 to 100 mPa•s), preferably from 3 to 15 mPa•s, and particularly preferably from 5 to 15 mPa•s. Even a conductive ink having a viscosity at 25°C outside the range described above as measured by a method other than using a falling-ball viscometer falls within the scope of the conductive ink of the present disclosure, as long as the viscosity falls within the range described above as measured using a falling-ball viscometer.

The conductive ink according to an embodiment of the present disclosure is excellent in dispersion stability, and, for example, when a conductive ink having a metal concentration of 65 wt.% is stored at 5°C, agglomeration of the metal nanoparticles can be suppressed in a period of 1 month or longer.

The conductive ink according an embodiment of the present disclosure has low viscosity and excellent applicability as described above. Furthermore, the conductive ink is excellent in dispersion stability of the surface-modified metal nanoparticles (A), and, even when containing the surface-modified metal nanoparticles (A) in a high concentration, can maintain good applicability. Furthermore, the conductive ink according to an embodiment of the present disclosure has excellent low-temperature sinterability and provides a sintered body with excellent substrate steady contact and conductivity through low-temperature sintering. Therefore, the conductive ink according to an embodiment of the present disclosure can be suitably used in an application of forming a wire or the like on a substrate (particularly, a substrate having low heat resistance such as a general-purpose plastic substrate, or a substrate that has high heat resistance, but is smooth, and thus is less likely to provide an anchoring effect, such as a glass substrate) by a printing method such as ink jet printing, dip coating printing, slit coating printing, spin coating printing, spray printing, gravure printing,

or flexographic printing.

Method for manufacturing electronic device

A method for manufacturing an electronic device according to an embodiment of the present disclosure includes: applying the conductive ink described above on a substrate by an inkjet printing method, dip coating printing, slit coating printing, spin coating printing, spray printing, a gravure printing method, or a flexographic printing method; and sintering the conductive ink.

As the thickness of the coating film obtained by applying the conductive ink, the thickness of the sintered body obtained by sintering the coating film is preferably, for example, from 0.1 to 5 μm (preferably, from 0.5 to 2 μm).

In the method for manufacturing an electronic device according to an embodiment of the present disclosure, the conductive ink is used, and thus sintering can be performed at low temperatures. The sintering temperature is, for example, 120°C or lower (the lower limit of the sintering temperature is, for example, 60°C, and more preferably 100°C in that the coating film can be sintered in a short time), particularly preferably 115°C or lower, and most preferably 110°C or lower. The sintering time is, for example, from 0.1 to 3 hours, preferably from 0.5 to 2 hours, and particularly preferably from 0.5 to 1 hour.

Using the conductive ink according to an embodiment of the present disclosure allows sintering of the metal nanoparticles to sufficiently proceed even by low-temperature sintering (e.g., even by sintering at a low temperature and in a short time, such as 120°C for 30 minutes). As a result, a sintered body having excellent substrate steady contact (particularly, a sintered body having excellent steady contact even to a substrate having excellent surface smoothness such as glass) is obtained. Therefore, even when a protective film is bonded to the sintered body, for example, for the purpose of damage prevention, the sintered body cannot be peeled together when the protective film is peeled.

Also, using the conductive ink according to an embodiment of the present disclosure allows sintering of the metal nanoparticles to sufficiently proceed even by low-temperature sintering (e.g., even by sintering at a low temperature and in a short time, such as 120°C for 30 minutes). As a result, a sintered body having excellent conductivity (a volume resistivity of, for example, 10 μΩcm or less, and preferably 8 μΩcm or less) is obtained. The conductivity (or volume resistivity) of the sintered body can be measured by the method described in Examples.

The use of the conductive ink according to an embodiment of the present disclosure provides a sintered body having excellent steady contact to a substrate as described above, and thus a substrate which has a smooth surface and is less likely to provide an anchoring effect, such as a glass substrate, can be suitably used as the substrate.

Using the conductive ink according to an embodiment of the present disclosure enables low-temperature sintering as described above, and thus in addition to a glass substrate and a heat-resistant plastic substrate such as a polyimide-based film, a general-purpose plastic substrate with low heat-resistant can also be suitably used, including a polyester-based film such as a polyethylene terephthalate (PET) film or a polyethylene naphthalate (PEN) film, or a polyolefin-based film such as polypropylene.

The method for manufacturing an electronic device according to an embodiment of the present disclosure provides an electronic device including, on a substrate, a wire or the like composed of a sintered body with excellent conductivity and substrate steady contact, as described above, easily and at a low cost.

The electronic device according to an embodiment of the present disclosure is suitably used, for example, in liquid crystal displays, organic EL displays, field emission displays (FED), IC cards, IC tags, solar cells, LED elements, organic transistors, condensers (capacitors), electronic paper, flexible batteries, flexible sensors, membrane switches, touch screens, and EMI shields.

Each aspect disclosed in the present specification can be combined with any other feature disclosed herein.

Examples

Hereinafter, although the invention of the present disclosure will be more specifically described by way of examples, each of configurations, combinations thereof, and the like in each embodiment are merely an example, and various additions, omissions, substitutions, and other changes may be made as appropriate without departing from the spirit of the invention of the present disclosure. The present disclosure is not limited by the embodiments and is limited only by the claims.

Preparative Example 1 (Preparation of surface-modified silver nanoparticles) Formation of complex

Silver oxalate (molecular weight: 303.78) was obtained from silver nitrate (available from Wako Pure Chemical Industries, Ltd.) and oxalic acid dihydrate (available from Wako Pure Chemical Industries, Ltd.).

Then, 20.0 g (65.8 mmol) of the silver oxalate was charged to a 500-mL flask, 30.0 g of n-butanol was added to this, and an n-butanol slurry of silver oxalate was prepared.

To this slurry, an amine mixture liquid of 57.8 g (790.1 mmol) of n-butylamine (a molecular weight of 73.14, available from Daicel Corporation), 40.0 g (395.0 mmol) of n-hexylamine (a molecular weight of 101.19, available from Tokyo Chemical Industry Co., Ltd.), 38.3 g (296.3 mmol) of n-octylamine (a molecular weight of 129.25, trade designation "FARMIN 08D", available from Kao Corporation), 18.3 g (98.8 mmol) of n-dodecylamine (a molecular weight of 185.35, trade designation "FARMIN 20D", available from Kao Corporation), and 40.4 g (395.0 mmol) of N,N-dimethyl-1,3-propanediamine (a molecular weight of 102.18, available from Koei Chemical Co., Ltd.) was added dropwise at 30°C.

After the dropwise addition, the mixture was stirred at 30°C for 2 hours to allow a complex forming reaction between silver oxalate and the amines to proceeded, and a white material (silver oxalate-amine complex) was obtained.

Thermal decomposition

After the formation of the silver oxalate-amine complex, the reaction solution temperature was raised from 30°C to approximately 105°C (from 103 to 108°C), then the silver oxalate-amine complex was thermally decomposed by heating for 1 hour in a state of maintaining the temperature, and a dark blue suspension in which surface-modified silver nanoparticles were suspended in the amine mixture liquid was obtained.

Washing

After cooling, 200 g of methanol was added to the resulting suspension, and the mixture was stirred. Then, the surface-modified silver nanoparticles were precipitated by centrifugation, and the supernatant was removed. Then, 60 g of methanol was added again, and the mixture was stirred, then the surface-modified silver nanoparticles were precipitated by centrifugation, and the supernatant was removed. Surface-modified silver nanoparticles in a wet state were thus obtained.

Example 1 (Preparation of silver ink)

The components other than the surface-modified silver nanoparticles were weighed out according to the formulation (unit: parts by weight) shown in Table 1 below, stirred for 1 hour in an oil bath at 80°C, and then mixed with the surface-modified silver nanoparticles in a wet state according to the formulation shown in Table 1 to obtain a dark blue silver ink (1) (silver concentration: 50 wt.%).

The surface-modified silver nanoparticles of the obtained silver ink (1) had an average particle diameter of 25 nm as determined by dynamic light scattering using the analyzer, trade name "Zetananosizer Series Nano-S" (available from Malvern Panalytical Ltd.).

Examples 2 to 8 and Comparative Examples 1 to 6

Silver inks (silver concentration: 50 wt.%) were obtained in the same manner as in Example 1 except that the formulation was changed as shown in Tables 1 and 2.

The viscosity and ejectability of each of the silver inks obtained in the Examples and the Comparative Examples were measured and evaluated by the following methods. The substrate steady contact and conductivity of the sintered body of each of the silver inks obtained in the Examples and the Comparative Examples were evaluated by the following methods.

Silver ink viscosity measurement

The viscosity (mPa•s) of each of the silver inks obtained in the Examples and the Comparative Examples was measured at 25°C using a falling-ball viscometer (trade name "Lovis 2000M", available from Anton Paar).

Silver ink ejectability evaluation

Each of the silver inks obtained in the Examples and the Comparative Examples was subjected to an ejection test using an inkjet printer (trade name "Inkjet Head KM512-SHX", available from Konica Minolta, Inc.) to evaluate the ejectability.

Evaluation Criteria
Good ejectability: The silver ink could be ejected well.
Poor ejectability: Flight bending occurred, or the nozzle orifice was clogged and the silver ink could not be ejected.

Evaluation of substrate steady contact of sintered body

The silver ink obtained in each of the Examples and the Comparative Examples was applied onto an alkali-free glass sheet to form a coating film. The formed coating film was sintered at 120°C for 30 minutes using a hot plate to obtain a sintered body having a thickness of approximately 1 μm .

A substrate steady contact evaluation test was performed on the obtained sintered body/alkali-free glass sheet laminate by the following method.

Specifically, 11 cuts were formed on the sintered body surface of the sintered body/alkali-free glass sheet laminate in the longitudinal direction at intervals of 1 mm using a cutter knife, and 11 cuts orthogonal to the cuts in the longitudinal direction were further formed in the lateral direction to create a grid of 100 squares. The substrate steady contact was evaluated from the proportion (residual rate: %) of the sintered body remaining on the alkali-free glass sheet when an adhesive tape (trade name "Paper Adhesive Tape No. 209", available from Nichiban Co., Ltd.) was strongly press-bonded to the grid, and then peeled.

Evaluation of conductivity of sintered body

The surface resistivity value of the sintered body obtained in the same manner as in the substrate steady contact evaluation of the sintered body was measured using a four-terminal method (Loresta GP MCP-T610), and the volume resistivity was calculated from the following equation to evaluate the conductivity.

$$\text{Volume resistivity } (\mu\Omega\text{cm}) = \text{surface resistivity} \times \text{film thickness}$$

[Table 1]

(Table 1

| | | Examples | | | Comparative Examples | | | | | |
|---|---|---|---|---|---|---|---|---|---|---|
| | | 1 | 2 | 3 | 1 | 2 | 3 | 4 | 5 | 6 |
| Surface-modified silver nanoparticles | | 58.2 | 58.2 | 58.2 | 58.2 | 58.2 | 58.2 | 58.2 | 58.2 | 58.2 |
| Dispersio n medium | Tetradecan e | 16.4 | 16.4 | 16.4 | 16.7 | 16.6 | 16.6 | 16.3 | 16.6 | 16.3 |
| | dl-Menthol | 24.6 | 24.6 | 24.6 | 25.1 | 24.8 | 24.8 | 24.5 | 24.8 | 24.5 |
| Polymer | SV-02 | 0.4 | | | | | | | | |
| | BL-1 | | 0.4 | | | | | | | |
| | B14S | | | 0.4 | | | | | | |
| | ASPU-121 | | | | | 0.4 | | | | |
| | KC1100 | | | | | | 0.4 | 1 | | |
| | UC-102 | | | | | | | | 0.4 | 1 |
| Amine mixture liquid | | 0.4 | 0.4 | 0.4 | | | | | | |
| Viscosity (mPa•s) | | 9 | 8 | 9 | 7 | 11 | 9 | 15 | 8 | 18 |
| Ejectability | | Good | Good | Good | Good | Poor | Good | Poor | Poor | Poor |
| Sintered body residual rate (%) | | 100 | 80 | 80 | 0 | 100 | 0 | 60 | 0 | 60 |
| Volume resistivity (μΩcm) | | 8 | 9 | 9 | 6 | 15 | 6 | 15 | 8 | 12000 |

[Table 2]

(Table 2)

| | | Examples | | | | | |
|---|---|---|---|---|---|---|---|
| | | 1 | 4 | 5 | 6 | 7 | 8 |
| Surface-modified silver nanoparticles | | 58.2 | 58.2 | 58.2 | 58.2 | 46.5 | 34.9 |
| Dispersion medium | Tetradecane | 16.4 | 14.4 | 12.3 | 10.3 | 21.5 | 25.7 |
| | dl-Menthol | 24.6 | 25.6 | 28.7 | 30.7 | 32.2 | 38.6 |
| Polymer | SV-02 | 0.4 | 0.4 | 0.4 | 0.4 | 0.4 | 0.4 |
| Amine mixture liquid | | 0.4 | 0.4 | 0.4 | 0.4 | 0.4 | 0.4 |
| Viscosity (mPa·s) | | 9 | 10 | 12 | 13 | 8 | 8 |
| Ejectability | | Good | Good | Good | Good | Good | Good |
| Sintered body residual rate (%) | | 100 | 100 | 100 | 100 | 100 | 100 |
| Volume resistivity (μΩcm) | | 8 | 7 | 7 | 7 | 8 | 9 |

The components shown in the table are as follows.

<Surface-modified metal nanoparticles>

- Surface-modified silver nanoparticles: Surface-modified silver nanoparticles obtained in Preparative Example 1

<Dispersion medium>

- Tetradecane: a boiling point of 253°C, a reagent available from Tokyo Chemical Industry Co., Ltd.
- (±)-Menthol: a boiling point of 212°C, a reagent available from Tokyo Chemical Industry Co., Ltd.

<Polymer>

- SV-02: Polyvinyl butyral resin, trade name "S-LEC SV-02", available from Sekisui Chemical Co., Ltd.
- BL-1: Polyvinyl butyral resin, trade name: S-LEC BL-1", available from Sekisui Chemical Co., Ltd.
- B14S: Polyvinyl butyral resin, trade name "Mowital B14S", available from Kuraray Co., Ltd.
- ASPU-121: Polyetherurethane resin, trade name "CRISVON ASPU-121", available from DIC Corporation
- KC1100: Acrylic resin, trade name "KC-1100", available from Kyoeisha Chemical Co., Ltd.
- UC-102: Isoprene rubber, trade name "Kuraprene UC-102", available from Kuraray Co., Ltd.

<Amine mixture liquid>

- Amine mixture liquid described in Preparative Example 1

For "SV-02" which is the polyvinyl butyral resin used in the Examples, the spectrum was measured using a KBr method by FT-IR (trade name "IR Affinity-1", available from Shimadzu Corporation).
FIG. 1 illustrates absorption peaks in a region from 1600 to 2000 $cm^{-1}$ of an FT-IR spectrum of the "SV-02". A peak at "1772.58 $cm^{-1}$", which is attributed to carboxylic acid, was observed.
Variations of embodiments of the present disclosure described above are additionally described below.

[1] A conductive ink containing components (A), (B), and (C) below, wherein a content of the component (C) is from

0.1 to 5.0 parts by weight relative to 100 parts by weight of the component (A), and a viscosity at 25°C is 100 mPa•s or less:

Component (A): surface-modified metal nanoparticles having a configuration in which surfaces of metal nanoparticles are coated with an organic protective agent;
Component (B): a dispersion medium containing an alcohol (b-1) and a hydrocarbon (b-2); and
Component (C): a polyvinyl acetal resin.

[2] The conductive ink according to [1], wherein a proportion of the organic protective agent in the component (A) is from 1 to 20 wt.% (preferably, from 1 to 10 wt.%) of a weight of the metal nanoparticles.
[3] The conductive ink according to [1] or [2], wherein the metal nanoparticles have an average primary particle diameter from 0.5 to 100 nm (preferably from 0.5 to 80 nm, more preferably from 1 to 70 nm, and even more preferably from 1 to 60 nm).
[4] The conductive ink according to any one of [1] to [3], wherein a metal constituting the metal nanoparticles is at least one type (preferably, silver) selected from the group consisting of gold, silver, copper, nickel, aluminum, rhodium, cobalt, and ruthenium.
[5] The conductive ink according to any one of [1] to [4], wherein the metal nanoparticles constituting the component (A) are silver nanoparticles.
[6] The conductive ink according to any one of [1] to [5], wherein the organic protective agent of the component (A) is a compound having at least one type of functional group (preferably, an amino group) selected from the group consisting of a carboxyl group, a hydroxyl group, an amino group, a sulfo group, and a thiol group.
[7] The conductive ink according to any one of [1] to [6], wherein the organic protective agent of the component (A) is a compound having at least an amino group (preferably, a compound having from 4 to 18 carbon atoms and having an amino group).
[8] The conductive ink according to any one of [1] to [7], wherein the alcohol (b-1) is an alicyclic secondary alcohol and/or an alicyclic tertiary alcohol.
[9] The conductive ink according to any one of [1] to [8], wherein a boiling point of the alcohol (b-1) is 130°C or higher (preferably 170°C or higher, more preferably 185°C or higher, and even more preferably 190°C or higher).
[10] The conductive ink according to any one of [1] to [9], wherein the boiling point of the alcohol (b-1) is 300°C or lower (preferably 250°C or lower, and more preferably 220°C or lower).
[11] The conductive ink according to any one of [1] to [10], wherein the hydrocarbon (b-2) includes an aliphatic hydrocarbon (particularly preferably a chain aliphatic hydrocarbon, and most preferably a chain aliphatic hydrocarbon having 15 or more carbon atoms).
[12] The conductive ink according to any one of [1] to [11], wherein a boiling point of the hydrocarbon (b-2) is 130°C or higher (preferably 170°C or higher, more preferably 190°C or higher, even more preferably 200°C or higher, preferably, still even more preferably 230°C or higher, particularly preferably 250°C or higher, and most preferably 270°C or higher).
[13] The conductive ink according to any one of [1] to [12], wherein the component (C) includes a polyvinyl butyral resin.
[14] The conductive ink according to any one of [1] to [13], wherein the polyvinyl acetal resin as the component (C) includes a polyvinyl acetal resin having a peak in a region from 1760 to 1800 $cm^{-1}$ in measurement by FT-IR.
[15] The conductive ink according to [14], wherein a functional group to which a characteristic peak appearing in the region from 1760 to 1800 $cm^{-1}$ in the measurement by FT-IR is attributed is derived from a carboxylic acid, a salt thereof, an ester thereof, an anhydride thereof, a chloride thereof, or any other derivative of carboxylic acid.
[16] The conductive ink according to any one of [1] to [15], wherein a weight average molecular weight of the polyvinyl acetal resin (C) is from $0.1 \times 10^4$ to $30.0 \times 10^4$ (preferably from $0.5 \times 10^4$ to $20.0 \times 10^4$, particularly preferably from $0.5 \times 10^4$ to $10.0 \times 10^4$, most preferably from $0.5 \times 10^4$ to $5.0 \times 10^4$, and especially preferably from $0.5 \times 10^4$ to $3.0 \times 10^4$).
[17] The conductive ink according to any one of [1] to [16], wherein a glass transition temperature (Tg) of the polyvinyl acetal resin as the component(C) is from 50 to 90°C (preferably from 55 to 85°C, and more preferably from 60 to 80°C).
[18] The conductive ink according to any one of [1] to [17], further containing a component (D) below:
Component (D): a dispersion stabilizer.
[19] The conductive ink according to [18], wherein the dispersion stabilizer as the component (D) is a compound having at least an amino group.
[20] The conductive ink according to [18] or [19], wherein the dispersion stabilizer as the component (D) is identical with the organic protective agent used in the preparation of the surface-modified metal nanoparticles (A).
[21] The conductive ink according to any one of [18] to [20], wherein a use amount of the dispersion stabilizer is from 10 to 500 parts by weight (preferably from 50 to 300 parts by weight) relative to 100 parts by weight of the polyvinyl acetal resin (C).

[22] The conductive ink according to any one of [1] to [21], wherein a content (in terms of metal element) of the surface-modified metal nanoparticles (A) in a total amount (100 wt.%) of the conductive ink is from 35 to 70 wt.% (a lower limit of the content is preferably 40 wt.%, particularly preferably 45 wt.%, most preferably 50 wt.%, and particularly preferably 55 wt.%; and an upper limit of the content is preferably 65 wt.%, and particularly preferably 60 wt.%).

[23] The conductive ink according to any one of [1] to [22], wherein a content of the dispersion medium (B) is from 20 to 100 parts by weight (preferably from 30 to 90 parts by weight, more preferably from 40 to 80 parts by weight, even more preferably from 50 to 75 parts by weight, particularly preferably from 55 to 75 parts by weight, and most preferably from 60 to 75 parts by weight) relative to 100 parts by weight of the surface-modified metal nanoparticles (A).

[24] The conductive ink according to any one of [1] to [23], wherein the content of the dispersion medium (B) in the total amount (100 wt.%) of the conductive ink is from 20 to 65 wt.% (preferably from 25 to 60 wt.%, more preferably from 30 to 55 wt.%, and most preferably from 30 to 50 wt.%).

[25] The conductive ink according to any one of [1] to [24], wherein a content of the alcohol (b-1) (particularly, monocyclic secondary alcohol) is from 15 to 70 parts by weight (preferably from 20 to 60 parts by weight, particularly preferably from 30 to 55 parts by weight, and most preferably from 35 to 55 parts by weight) relative to 100 parts by weight of the surface-modified metal nanoparticles (A).

[26] The conductive ink according to any one of [1] to [25], wherein a content of the hydrocarbon (b-2) (particularly, aliphatic hydrocarbon) is from 5 to 50 parts by weight (preferably from 10 to 40 parts by weight, particularly preferably from 15 to 30 parts by weight, and most preferably from 15 to 28 parts by weight) relative to 100 parts by weight of the surface-modified metal nanoparticles (A).

[27] The conductive ink according to any one of [1] to [26], wherein a total content of the alcohol (b-1) and the hydrocarbon (b-2) is 70 wt.% or greater (particularly preferably 75 wt.% or greater, and most preferably 80 wt.% or greater) of a total amount of the component (B).

[28] The conductive ink according to any one of [1] to [27], wherein a content ratio of the alcohol (b-1) to the hydrocarbon (b-2) ((b-1)/(b-2) (weight ratio)) is from 50/50 to 95/5 (for example, from 40/60 to 95/5, preferably from 45/55 to 90/10, more preferably from 50/50 to 85/15, and particularly preferably from 60/40 to 80/20).

[29] The conductive ink according to any one of [1] to [28], wherein a content of the polyvinyl acetal resin (C) is from 0.1 to 5.0 parts by weight relative to 100 parts by weight (in terms of metal element) of the surface-modified metal nanoparticles (A) (a lower limit of the content is preferably 0.2 parts by weight, particularly preferably 0.3 parts by weight, most preferably 0.4 parts by weight, and particularly preferably 0.5 parts by weight; an upper limit of the content is preferably 3.0 parts by weight, particularly preferably 2.0 parts by weigh, and most preferably 1.0 part by weight).

[30] The conductive ink according to any one of [1] to [29], wherein the content of the polyvinyl acetal resin (C) in the total amount (100 wt.%) of the conductive ink is from 0.05 to 3.0 wt.% (a lower limit of the content is preferably 0.1 wt.%, particularly preferably 0.15 wt.%, most preferably 0.2 wt.%, and particularly preferably 0.25 wt.%; and an upper limit of the content is preferably 2.5 wt.%, particularly preferably 2.0 wt.%, and most preferably 1.0 wt.%).

[31] The conductive ink according to any one of [1] to [30], wherein a proportion of a total amount of the surface-modified metal nanoparticles (A), the dispersion medium (B), and the polyvinyl acetal resin (C) in the total amount (100 wt.%) of the conductive ink is 70 wt.% or greater (preferably 80 wt.% or greater, and particularly preferably 90 wt.% or greater).

[32] The conductive ink according to any one of [1] to [31], wherein a viscosity at 25°C of the conductive ink, as measured using a falling-ball viscometer, is 100 mPa•s or less (for example, from 2 to 100 mPa s, preferably from 3 to 15 mPa•s, and particularly preferably from 5 to 15 mPa•s).

[33] The conductive ink according to any one of [1] to [32], wherein a sintered body obtained by sintering the conductive ink at 120°C for 30 minutes has a volume resistivity of 10 μΩcm or less (preferably, 8 μΩcm or less).

[34] The conductive ink according to any one of [1] to [33], which is used in ink j et printing, dip coating printing, slit coating printing, spin coating printing, or spray printing.

[35] A method for manufacturing the conductive ink described in any one of [1] to [34], the method including:

mixing the component (B) and the component (C) to prepare a mixed solution; and
further mixing the component (A) with the mixed solution.

[36] The method for manufacturing the conductive ink according to [35], wherein the mixing of the component (B) and the component (C) to prepare the mixed solution further includes mixing a component (D) below:
Component (D): a dispersion stabilizer.

[37] A method for manufacturing an electronic device, the method including:

applying the conductive ink described in any one of [1] to [34] on a substrate by ink jet printing, dip coating printing, slit coating printing, spin coating printing, or spray printing; and
sintering the conductive ink.

[38] An electronic device including a sintered body of the conductive ink described in any one of [1] to [34] on a substrate.

Industrial Applicability

The conductive ink of the present disclosure is useful in manufacturing an electronic device (for example, an electronic circuit) with a wire, an electrode, or the like.

## Claims

1. A conductive ink comprising components (A), (B), and (C) below, wherein a content of the component (C) is from 0.1 to 5.0 parts by weight relative to 100 parts by weight of the component (A), and a viscosity at 25°C is 100 mPa•s or less:

   Component (A): surface-modified metal nanoparticles having a configuration in which surfaces of metal nanoparticles are coated with an organic protective agent;
   Component (B): a dispersion medium comprising an alcohol (b-1) and a hydrocarbon (b-2); and
   Component (C): a polyvinyl acetal resin.

2. The conductive ink according to claim 1, wherein a total content of the alcohol (b-1) and the hydrocarbon (b-2) is 70 wt.% or greater of a total amount of the component (B).

3. The conductive ink according to claim 1 or 2, wherein a content ratio of the alcohol (b-1) to the hydrocarbon (b-2) ((b-1)/(b-2) (weight ratio)) is from 50/50 to 95/5.

4. The conductive ink according to any one of claims 1 to 3, wherein the organic protective agent of the component (A) is a compound having at least one type of functional group selected from the group consisting of a carboxyl group, a hydroxyl group, an amino group, a sulfo group, and a thiol group.

5. The conductive ink according to any one of claims 1 to 4, wherein the organic protective agent of the component (A) is a compound having at least an amino group.

6. The conductive ink according to any one of claims 1 to 5, wherein the alcohol (b-1) is an alicyclic secondary alcohol and/or an alicyclic tertiary alcohol.

7. The conductive ink according to any one of claims 1 to 6, wherein the hydrocarbon (b-2) comprises an aliphatic hydrocarbon.

8. The conductive ink according to any one of claims 1 to 7, wherein a weight average molecular weight of the polyvinyl acetal resin as the component (C) is from $0.1 \times 10^4$ to $30.0 \times 10^4$.

9. The conductive ink according to any one of claims 1 to 8, wherein the component (C) comprises a polyvinyl butyral resin.

10. The conductive ink according to any one of claims 1 to 9, wherein the polyvinyl acetal resin as the component (C) comprises a polyvinyl acetal resin having a peak in a region from 1760 to 1800 $cm^{-1}$ in measurement by FT-IR.

11. The conductive ink according to any one of claims 1 to 10, wherein a sintered body obtained by sintering the conductive ink at 120°C for 30 minutes has a volume resistivity of 10 μΩcm or less.

12. The conductive ink according to any one of claims 1 to 11, wherein the metal nanoparticles constituting the component (A) are silver nanoparticles.

**13.** The conductive ink according to any one of claims 1 to 12, which is used in ink jet printing, dip coating printing, slit coating printing, spin coating printing, or spray printing.

**14.** The conductive ink according to any one of claims 1 to 13, further comprising a component (D) below:
Component (D): a dispersion stabilizer.

**15.** The conductive ink according to claim 14, wherein the dispersion stabilizer as the component (D) is a compound having at least an amino group.

**16.** A method for manufacturing the conductive ink described in any one of claims 1 to 13, the method comprising:

mixing a component (B) and a component (C) to prepare a mixed solution; and
further mixing a component (A) with the mixed solution.

**17.** The method for manufacturing the conductive ink according to claim 16, wherein the mixing of the component (B) and the component (C) to prepare the mixed solution further comprises mixing a component (D) below:
Component (D): a dispersion stabilizer.

**18.** A method for manufacturing an electronic device, the method comprising:

applying the conductive ink described in any one of claims 1 to 15 on a substrate by ink jet printing, dip coating printing, slit coating printing, spin coating printing, or spray printing; and
sintering the conductive ink.

**19.** An electronic device comprising a sintered body of the conductive ink described in any one of claims 1 to 15 on a substrate.

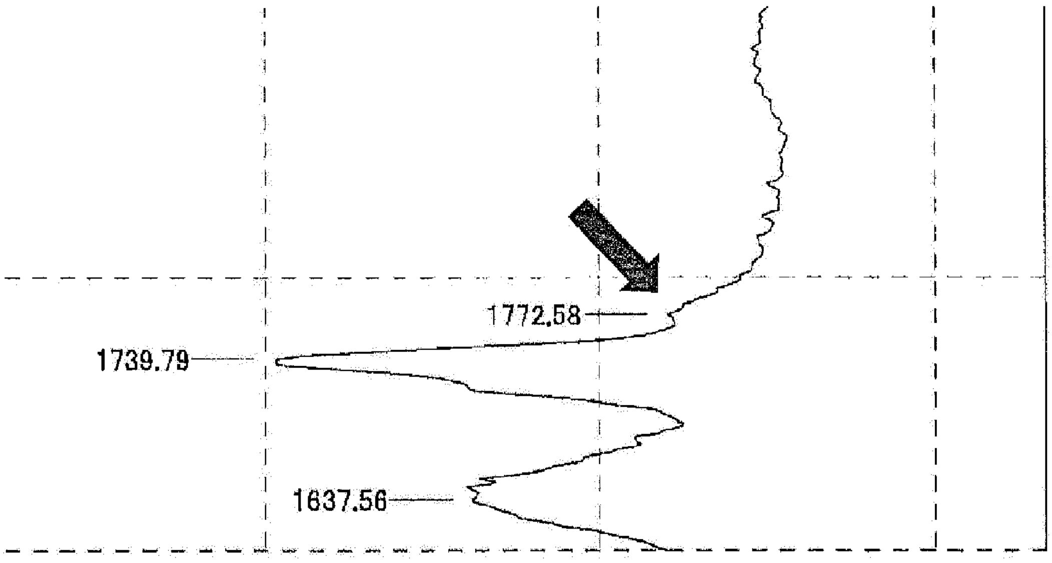


FIG. 1

## INTERNATIONAL SEARCH REPORT

International application No. PCT/JP2021/025305

A. CLASSIFICATION OF SUBJECT MATTER
Int. Cl. C09D11/16(2014.01)i, C09D11/52(2014.01)i, H01B1/00(2006.01)i, H01B1/22(2006.01)i, H01B13/00(2006.01)i
FI: H01B1/22 A, C09D11/16, H01B13/00 503Z, H01B13/00 503D, H01B1/00 E, C09D11/52

According to International Patent Classification (IPC) or to both national classification and IPC

B. FIELDS SEARCHED

Minimum documentation searched (classification system followed by classification symbols)
Int. Cl. C09D11/16, C09D11/52, H01B1/00, H01B1/22, H01B13/00

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2017/175661 A1 (DAICEL CORP.) 12 October 2017 (2017-10-12), claims | 1-19 |
| A | JP 2016-121241 A (SHOWA DENKO KABUSHIKI KAISHA) 07 July 2016 (2016-07-07), paragraph [0081], table 1 | 1-19 |

☐ Further documents are listed in the continuation of Box C.　☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 07.09.2021 | 14.09.2021 |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**
Information on patent family members

International application No.
PCT/JP2021/025305

| Patent Documents referred to in the Report | Publication Date | Patent Family | Publication Date |
|---|---|---|---|
| WO 2017/175661 A1 | 12.10.2017 | US 2019/0119519 A1<br>claims<br>EP 3441435 A1<br>CN 108884346 A<br>KR 10-2018-0128476 A<br>TW 201807083 A | |
| JP 2016-121241 A | 07.07.2016 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2020118058 A
- WO 2014021270 A